# EUROPEAN PATENT APPLICATION

(11) **EP 4 726 953 A1**
(43) Date of publication of application: **15.04.2026**
(21) Application number: 24823158.1
(22) Date of filing: 15.05.2024
(51) Int. Cl.: H02J 7/00, B64C 27/04, B64C 27/26, B64C 27/28, B64C 29/00, B64D 27/24, B64U 10/13, B64U 10/17, B64U 10/20, B64U 50/19, H01M 10/48

(54) **MONITORING DEVICE AND PROGRAM**

(30) Priority: 12.06.2023 JP 2023096456
(71) Applicant: DENSO CORPORATION, Kariya-city, Aichi 448-8661 (JP)
(72) Inventor: NAKAMURA, Masaya, Kariya-city, Aichi 448-8661 (JP); YOSHIDA, Shuhei, Kariya-city, Aichi 448-8661 (JP)
(74) Representative: TBK
(86) International application number: PCT/JP2024/017890
(87) International publication number: WO 2024/257536

(57) **Abstract**

A monitoring device (50) monitors a battery (14) mounted on an eVTOL. The monitoring device (50) includes an acquisition unit (51) and an output unit (53). The acquisition unit (51) acquires information on temperature unevenness of a battery (14) that occurs due to movement of an eVTOL in the vertical direction. The output unit (53) outputs a monitoring result when a predetermined condition, which is related to an abnormality of the battery (14), is satisfied based on information related to the temperature unevenness. By monitoring the temperature unevenness, an abnormality of the battery (14), which is caused by progress of partial deterioration of the battery (14), can be detected in an early stage. Thus, safety of flight can be enhanced.

## Description

### CROSS REFERENCE TO RELATED APPLICATION

The present application is based on Japanese Patent Application No. 2023-96456 filed on June 12, 2023. The entire disclosures of all of the above applications are incorporated herein by reference.

### TECHNICAL FIELD

The present disclosure relates to a monitoring device and a program.

### BACKGROUND ART

Patent Literature 1 discloses a method for controlling an electric flight vehicle. The disclosure of the prior art literature is incorporated herein by reference as an explanation of the technical elements in this disclosure.

### PRIOR ART LITERATURE

### PATENT LITERATURE

PATENT LITERATURE 1: JP2021-172101A

### SUMMARY OF INVENTION

In Patent Literature 1, the battery state is monitored, and once an abnormality such as a short circuit is detected, measures are taken to avoid the abnormality. In the above respects and in other respects not mentioned, further improvements are required in the monitoring device and the program.

It is an object of the disclosure to provide a monitoring device that enables to enhance flight safety and a program.

According to an aspect of the present disclosure, a monitoring device is configured to monitor a battery mounted on an electric flight vehicle. The monitoring device comprises: an acquisition unit configured to acquire information on temperature unevenness of the battery, the temperature unevenness being caused due to movement of the electric flight vehicle in the vertical direction; and an output unit configured to output a monitoring result, when a predetermined condition related to an abnormality of the battery is satisfied based on the information on the temperature unevenness.

When the flight vehicle moves in the vertical direction, the battery is required to discharge a large current for a certain period. Because of this, the temperature unevenness becomes apparent in the battery due to the temperature unevenness, and partial deterioration occurs in the battery. Due to the partial deterioration, the electric resistance increases, and heat generation when discharging the large current further increases. Thus, the partial deterioration further progresses. The monitoring device according to the present disclosure monitors the temperature unevenness thereby to enable to detect an abnormality of the battery accompanied with progress in the partial deterioration at an early stage. Thus, safety of flight can be enhanced.

According to another aspect of the present disclosure, a program is stored in a storage medium for monitoring a battery, which is mounted on an electric flight vehicle. The program comprises: instructions to be executed by a processor to cause the processor to acquire information on temperature unevenness of the battery, the temperature unevenness being caused due to movement of the electric flight vehicle in a vertical direction, and output a monitoring result, when a predetermined condition related to an abnormality of the battery is satisfied based on the information on the temperature unevenness.

When the flight vehicle moves in the vertical direction, the battery is required to discharge a large current for a certain period. Because of this, the temperature unevenness becomes apparent in the battery due to the temperature unevenness, and partial deterioration occurs in the battery. Due to the partial deterioration, the electric resistance increases, and heat generation when discharging the large current further increases. Thus, the partial deterioration further progresses. The program according to the present disclosure monitors the temperature unevenness thereby to enable to detect an abnormality of the battery accompanied with progress in the partial deterioration at an early stage. Thus, safety of flight can be enhanced.

According to another aspect of the present disclosure, a monitoring device is configured to monitor a battery mounted on an electric flight vehicle. The monitoring device comprises: an acquisition unit configured to acquire a characteristic including a temperature rise characteristics of the battery, which is before reaching the maximum temperature, and/or a temperature relaxation characteristics of the battery, which is after reaching the maximum temperature, due to movement of the electric flight vehicle in the vertical direction; and an output unit configured to output a monitoring result, when a predetermined condition related to an abnormality of the battery is satisfied based on the characteristic.

When the electric flight vehicle moves vertically, a battery is required to discharge a large current for a certain period of time. This causes the battery to deteriorate. As the battery deteriorates, a resistance of the battery increases, and it causes even more heat when discharging a large current, promotes further deterioration. According to the disclosed monitoring device, the battery state is monitored using the temperature rise characteristic before the maximum temperature is reached and/or the temperature relaxation characteristic after the maximum temperature is reached, so that the battery abnormality caused by progression of deterioration can be detected in an early stage. Thus, the safety of the flight can be enhanced.

The disclosed aspects in this specification adopt different technical solutions from each other in order to achieve their respective objectives. Reference numerals in parentheses in the claims exemplify the correspondence with portions of embodiments described later, and are not intended to limit the technical scope. The objects, features, and advantages disclosed in this description will become apparent by referring to following detailed descriptions and accompanying drawings.

### BRIEF DESCRIPTION OF THE DRAWINGS

FIG. 1 is a diagram a configuration of an eVTOL and a ground station.
FIG. 2 is a diagram showing a functional layout of an operation management system.
FIG. 3 is a view showing a power profile.
FIG. 4 is a plan view showing a battery.
FIG. 5 is a cross-sectional view taken along a line V-V in FIG. 4.
FIG. 6 is a diagram showing a battery cell.
FIG. 7 is a view showing a temperature unevenness inside the battery cell.
FIG. 8 is a view showing expansion of the temperature unevenness with progress of partial deterioration.
FIG. 9 is a diagram showing the temperature unevenness between battery cells inside an assembled battery.
FIG. 10 is a diagram showing a monitoring device.
FIG. 11 is a view showing temperature unevenness information.
FIG. 12 is a view showing a relationship among a battery discharge characteristic, the battery temperature unevenness, and a degree of partial deterioration.
FIG. 13 is a flowchart illustrating an example of a control method.
FIG. 14 is a flowchart illustrating another example of a control method.

### DESCRIPTION OF EMBODIMENTS

Hereinafter, multiple embodiments will be described with reference to the drawings. The same reference numerals are assigned to the corresponding elements in each embodiment, and thus, duplicate descriptions may be omitted. When only a part of the configuration is described in the respective embodiments, the configuration of the other embodiments described before may be applied to other parts of the configuration. Further, it is possible to not only combine configurations as specified in the description of the embodiments but also partially combine configurations of embodiments even though not specified herein as long as the combination does not cause difficulty.

A monitoring device, a monitoring method, and a program described below are applied to an electric flight vehicle. The description of A and/or B means at least one of A and B. That is, the A and/or B can include only A, only B, and both A and B.

### First Embodiment:

An electric flight vehicle includes a motor (rotating electrical machine) as a drive source for movement. The electric flight vehicle may be referred to as an electric airplane, an electric aircraft, or the like. The electric flight vehicle can move vertically and horizontally. The electric flight vehicle is capable of moving in a direction that has both vertical and horizontal components, in other words, in an oblique direction. The electric flight vehicle includes, for example, electric vertical takeoff and landing aircraft (eVTOL), electric short takeoff and landing aircraft (eSTOL), drones, etc. The eVTOL is an abbreviation for electric Vertical Take-Off and Landing aircraft. The eSTOL is an abbreviation of an electronic short distance take-off and landing aircraft.

The electric aircraft may be either a manned vehicle or an unmanned vehicle. In the case of a manned aircraft, the electric flight vehicle is operated by a pilot as an operator. In the case of an unmanned vehicle, the electric flight vehicle can be controlled remotely by an operator or automatically by a control system. As an example, the electric flight vehicle in this embodiment is an eVTOL.

### <eVTOL>

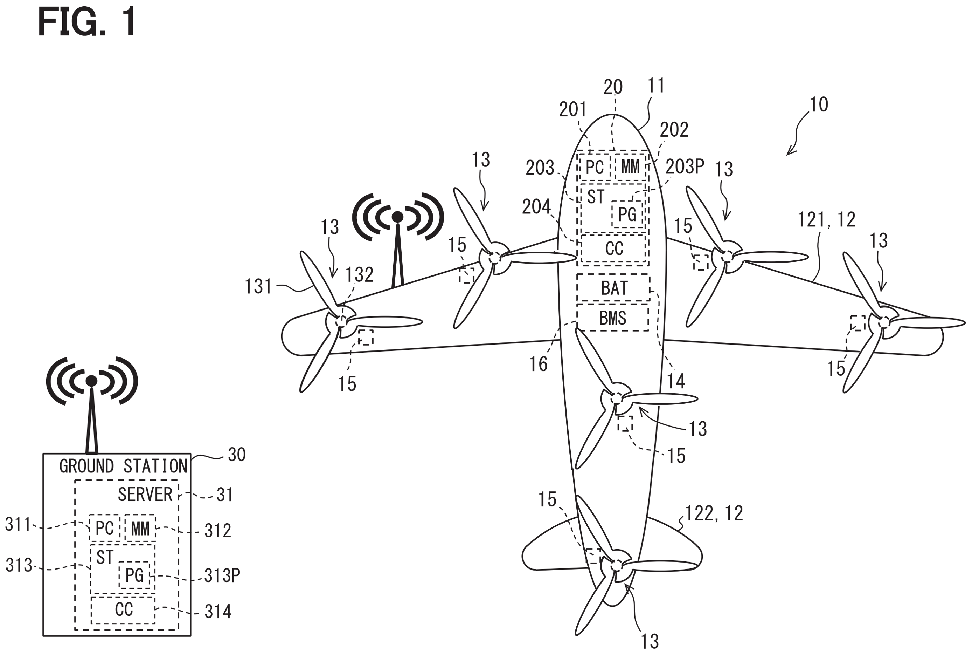

FIG. 1 shows the eVTOL and a ground station. As shown in FIG. 1, the eVTOL 10 includes an airframe main body 11, fixed wings 12, rotary wings 13, a battery 14, EPUs 15 and BMS 16.

The airframe main body 11 is a body portion of an airframe. The airframe main body 11 extends in a front-rear direction. The airframe main body 11 includes an occupant compartment for carrying occupants and/or a luggage compartment in which luggage is loaded.

Each of the fixed wings 12 is a wing portion of the airframe and is continuous to the airframe main body 11. The fixed wings 12 provide the gliding lift. The gliding lift is the lift generated by the fixed wings 12. The fixed wings 12 may include a main wing 121 and a tail wing 122. The main wing 121 extends to the left and right from in the vicinity of the center of the airframe main body 11 along the front-rear direction. The tail wing 122 extends in the left-right direction from a rear portion of the airframe main body 11. A shape of the fixed wing 12 is not particularly limited. For example, a swept-back wing, a delta wing, a straight wing, and the like may be used.

Multiple rotary wings 13 are provided in the airframe. At least a part of the multiple rotary wings 13 may be provided on the fixed wing 12. At least a part of the multiple rotary wings 13 may be provided on the airframe main body 11. The number of the rotary wings 13 provided on the eVTOL 10 is not particularly limited. Multiple rotary wings 13 may be provided on both the airframe main body 11 and the main wing 121.

Each of the rotary wings 13 may be referred to as a rotor, a propeller, a fan, or the like. The rotary wings 13 each have blades 131 and a shaft 132. The blades 131 are attached to the shaft 132. The blades 131 are vanes that rotate together with the shaft 132. Multiple blades 131 extend radially around the axis of the shaft 132. The shaft 132 is a rotation axis of a rotary wing 13 and is rotated by a motor of an EPU 15.

The rotary wings 13 generate a propulsive force by rotation. The thrust primarily acts as rotational lift on the eVTOL 10 during takeoff and landing operations. The rotary wings 13 primarily provide rotational lift during takeoff and landing operations. The rotational lift is the lift generated by the rotation of the rotary wings 13. During takeoff and landing operations, the rotary wings 13 may provide only rotational lift, or may provide both rotational lift and forward thrust. The rotary wing 13 provides the rotational lift when the eVTOL 10 hovers.

The thrust primarily acts as propulsive force on the eVTOL 10 during cruising operations. The rotary wings 13 primarily provide thrust during cruising operations. During cruising operations, the rotary wings 13 may provide only thrust or may provide both lift and thrust.

The battery (BAT) 14 is a device for driving the rotary wings 13. The battery 14 is sometimes referred to as a battery pack. The battery 14 is capable of storing direct current power and includes chargeable battery cells. The battery 14 includes at least one assembled battery having multiple battery cells. The battery cell is a secondary battery that generates an electromotive voltage by a chemical reaction. Each battery cell is, for example, a lithium ion secondary battery, a nickel-metal hydride secondary battery, or the like. Each battery cell may be a secondary battery in which an electrolyte is a liquid, or may be what is called an all-solid-state battery in which an electrolyte is a solid. Each battery cell may have any configuration as long as the battery reaction occurs by ions (electrolyte) contributing to the battery reaction moving between positive and negative electrodes via an electrolytic solution and/or a solid electrolyte. The eVTOL 10 may include a fuel cell and a generator in addition to the battery 14 as a power source that supplies power to the equipment. The battery 14 supplies electric power to the EPUs 15. The battery 14 may supply power to auxiliary machinery (not shown) such as an air conditioner, an ECU 20 (described later), a lift adjustment mechanism (not shown), and the like.

The battery 14 of the eVTOL 10 is required to have high capacity and high output performance. For this reason, battery cells that can obtain high capacity and high output are preferable. In terms of output, battery cells having low resistance in a wide SOC region are preferable. In particular, battery cells having low resistance and high output even in a low SOC region are preferable. The SOC is an abbreviation of a state of charge.

A positive electrode material for the battery cells may be, for example, LCO, NMC, NCA, LFP, or LMFP. LCO is lithium cobalt oxide (LiCoO₂). NMC is a lithium nickel cobalt manganese oxide (Li(NiMnCo)O₂). NCA is lithium nickel cobalt aluminate (Li(NiCoAl)O₂). LFP is lithium iron phosphate (LiFePO₄). LMFP is lithium manganese iron phosphate (LiFeₓMn_{y}PO₄). LCO, NMC, and NCA are layered compounds.

A negative electrode material for the battery cells may be, for example, a carbon-based material such as hard carbon or soft carbon, a silicon-based material, a lithium-based material, or a titanium-based material such as LTO or NTO. LTO is lithium titanate (Li₄Ti₅O₁₂). NTO is niobium titanium oxide (TiNb₂O₇). In particular, a negative electrode of a carbon material or a negative electrode of a titanium material, which has low resistance in the low SOC region is preferable.

The EPUs 15 rotate and drive the rotary wings 13 that provide thrust to the eVTOL 10. The EPUs 15 are equipment for rotationally driving the rotary wings 13. EPU is an abbreviation for Electric Propulsion Unit. Each EPU 15 corresponds to an electric propulsion device. Each EPU 15 is equipped with a motor. Each EPU 15 may include an inverter and an ESC in addition to the motor. ESC is an abbreviation for Electronic Speed Controller. The number of the EPUs 15 may be the same as the number of the rotary wings 13. For example, the eVTOL 10 may include six EPUs 15. The EPU 15 and the rotary wing 13 are connected in a one-to-one relationship. Alternatively, two or more rotary wings 13 may be connected to a single EPU 15 via a gear box.

The BMS 16 monitors the state of the unit batteries that constitute the battery 14. BMS is an abbreviation for Battery Management System. The BMS 16 is capable of monitoring the voltage, current, temperature, internal resistance, SOC, SOH, and other safety-related states of the battery 14, such as the internal pressure and gas leakage. The SOH is an abbreviation of a state of health. The BMS 16 may be provided integrally with the battery 14. The BMS 16 may be provided separately from the battery 14. A part of the BMS 16 may be provided inside the battery 14 and another part may be provided outside the battery 14.

The BMS 16 may be provided for each assembled battery. One BMS 16 may be provided for multiple assembled batteries. One BMS 16 may be provided for all the assembled batteries. When there are multiple BMSs 16, a function for controlling all the BMSs 16 may be provided separately from the BMS 16 or may be provided integrally with the BMS 16.

The eVTOL 10 further includes an ECU 20 and an auxiliary machine (not shown). ECU is an abbreviation for Electronic Control Unit. The eVTOL 10 may include a lift adjustment mechanism (not shown). The lift adjustment mechanism adjusts the gliding lift of the fixed wings 12. The lift adjustment mechanism increases or decreases the gliding lift generated by the fixed wings 12. The eVTOL 10 may be equipped with, for example, a tilt mechanism or flaps as the lift adjustment mechanism. The tilt mechanism is driven to adjust the tilt angle of the rotary wings 13. The flaps are movable wing pieces and provided on the fixed wings 12.

### <Operation Management System>

The operation management system is a system for creating an operation plan, monitoring an operation status, collecting and managing information related to an operation, supporting the operation, and the like. At least a part of functions of the operation management system may be arranged in an internal computer of the eVTOL 10. At least a part of the functions of the operation management system may be arranged in an external computer that can wirelessly communicate with the eVTOL 10. The external computer may be a server 31 in a ground station 30 as shown in FIG. 1. The ground station 30 can wirelessly communicate with the eVTOL 10. The ground station 30 can wirelessly communicate with other ground stations.

As an example, in the present embodiment, a part of the functions of the operation management system is arranged in the ECU 20 of the eVTOL 10, and a part of the functions of the operation management system is provided in the server 31 of the ground station 30. The functions of the operation management system are shared between the ECU 20 and the server 31.

As shown in FIG. 1, the ECU 20 includes a processor (PC) 201, a memory (MM) 202, a storage (ST) 203, and a communication circuit (CC) 204 for wireless communication. The processor 201 executes various processes by accessing the memory 202. The memory 202 is a rewritable volatile storage medium. The memory 202 is, for example, a RAM. The RAM is an abbreviation of a random access memory. The storage 203 is a rewritable nonvolatile storage medium. The storage 203 stores a program (PG) 203P to be executed by the processor 201. The program 203P constructs multiple functional units by causing the processor 201 to execute multiple instructions. The ECU 20 may include multiple processors 201.

Similar to the ECU 20, the server 31 includes a processor (PC) 311, a memory (MM) 312, a storage (ST) 313, and a communication circuit (CC) 314. The processor 311 executes various processes by accessing the memory 312. The memory 312 is a rewritable volatile storage medium, for example, a RAM. The storage 313 is a rewritable nonvolatile storage medium. The storage 313 stores a program (PG) 313P to be executed by the processor 311. The program 313P constructs multiple functional units by causing the processor 311 to execute multiple instructions. The server 31 may include multiple processors 311.

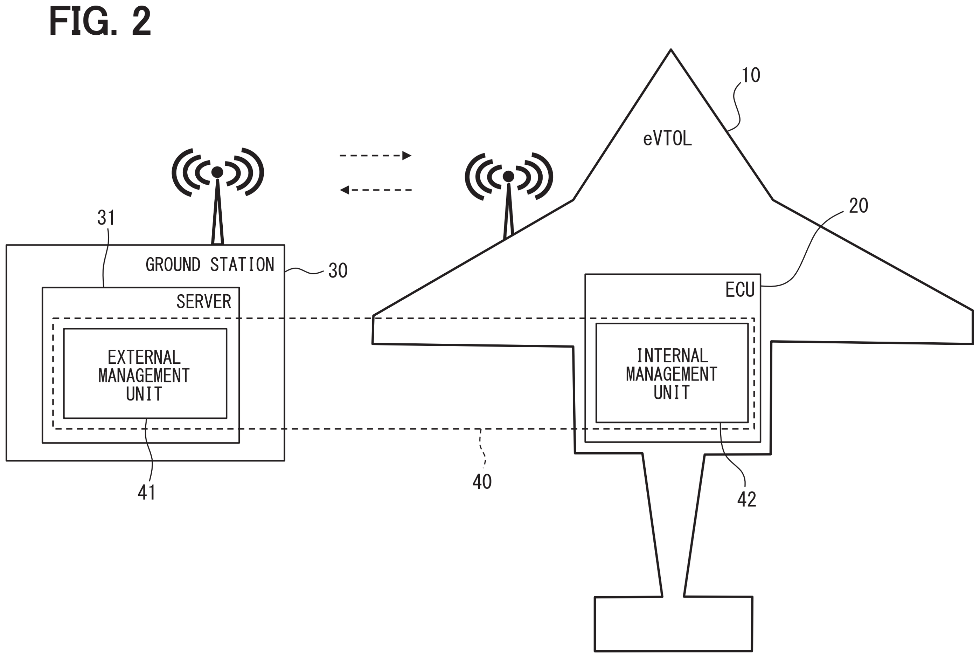

FIG. 2 shows a functional arrangement of the operation management system. The operation management system 40 shown in FIG. 2 includes an external management unit 41 and an internal management unit 42. The external management unit 41 is functionally disposed in the server 31 of the ground station 30. The internal management unit 42 is functionally disposed in the ECU 20 of the eVTOL 10. In this way, a part of the functions of the operation management system 40 may be provided in the server 31, and the other part of the functions may be arranged in the ECU 20. The external management unit 41 and the internal management unit 42 can wirelessly communicate with each other. The internal management unit 42 can communicate with various devices arranged in the eVTOL 10 in a wired or wireless manner.

### <Power Profile>

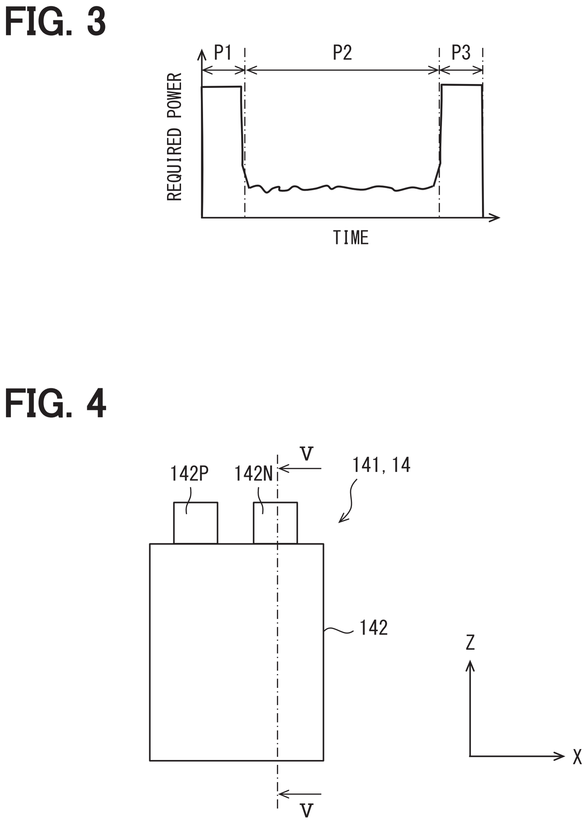

FIG. 3 shows a power profile from take-off to landing of the eVTOL 10. A power profile of an electric flight vehicle other than the eVTOL 10 is similar to that of the eVTOL 10. A period P1 is referred to as a takeoff time, a takeoff flight time, a takeoff operation time, or the like. A period P2 is referred to as a cruising time, a cruising flight time, a cruising operation time, or the like. A period P3 is referred to as a landing time, a landing flight time, a landing operation time, or the like. The periods P1 and P3 are referred to as a takeoff and landing time, a takeoff and landing flight time, a takeoff and landing operation time, or the like. For convenience, in FIG. 3, required power, that is, an output is constant in substantially an entire region of each of the periods P1 and P3.

The eVTOL 10 ascends from a take-off point to a cruising start point in the period P1. The eVTOL 10 cruises at a predetermined altitude in the period P2. The eVTOL 10 descends from an end point of the period P2 to a landing point in the period P3. A movement of the eVTOL 10 mainly includes a horizontal direction component in the period P2 and mainly includes a vertical direction component in each of the periods P1 and P3. During the periods P1 and P3 when moving in the vertical direction, the operation of the rotary wings 13 requires high output continuously for a predetermined time.

Thus, a high output load is applied to the battery 14 during the vertical movement. The more power is required during the takeoff and landing. The output of the battery 14 varies greatly between when it moves vertically and when it moves horizontally. The output of the battery 14 varies greatly between the takeoff and landing and the cruising. The vertical movement, particularly the high output during the takeoff and landing, would cause temperature unevenness inside the battery 14, would cause partial deterioration of the battery 14, and would lead to an abnormality in the battery 14.

### <Battery>

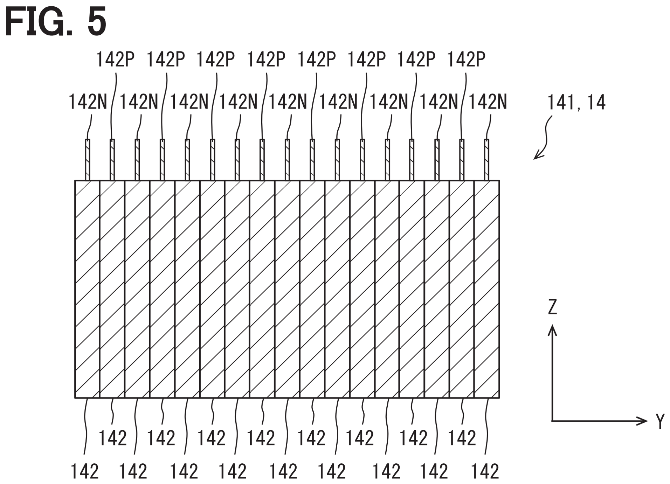

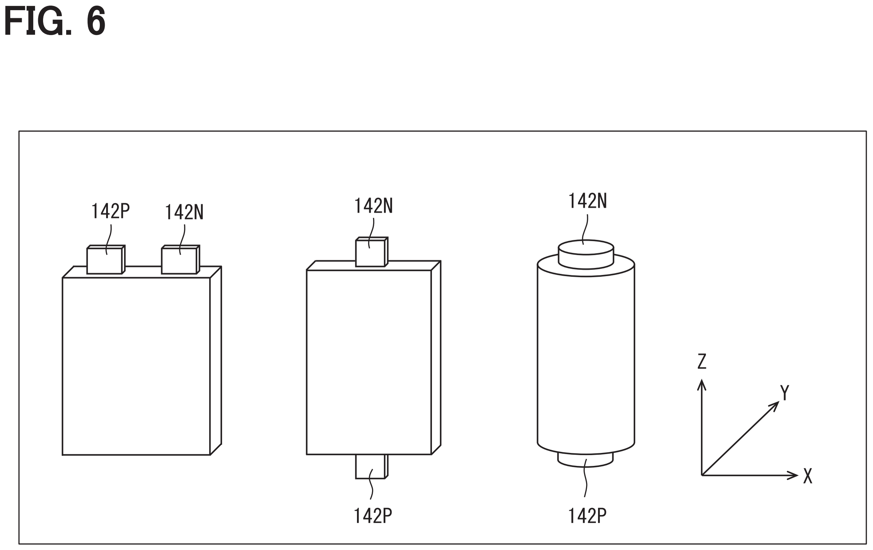

FIG. 4 shows an example of the battery 14. FIG. 5 is a cross-sectional view taken along a line V-V in FIG. 4. FIG. 5 shows a simplified configuration of the battery cells. FIG. 6 is a diagram showing an arrangement of electrode terminals. In the following, a height direction of each battery cell is referred to as a Z direction, a direction perpendicular to the Z direction is referred to as a Y direction, and a direction perpendicular to both the Z direction and the Y direction is referred to as an X direction. In FIG. 5, for the sake of convenience, the entirety of the battery cells is shown with a metal hatching.

As shown in FIGS. 4 and 5, the battery 14 includes at least one assembled battery 141. The assembled battery 141 includes multiple battery cells 142. The multiple battery cells 142 may have a common structure, or some of the multiple battery cells 142 may have a structure that is different from the other of the multiple battery cells 142. The number and arrangement of the battery cells 142 are not particularly limited. The multiple battery cells 142 may be connected in series, or in combination of series connection and parallel connection.

Each battery cell 142 includes a power generating element and a battery case that accommodates the power generating element. The battery case is an outer casing for the battery cell 142. The battery case may be formed, for example, using a metal material or a laminate film. The shape of the battery cell 142, i.e., the battery case, is not particularly limited. It may be of a rectangular shape, a laminated type, or a cylindrical shape.

Each battery cell 142 includes electrode terminals 142P and 142N. As shown in FIG. 6, the electrode terminals 142P and 142N may be provided on a common surface, or on different surfaces. For example, they may be provided on one surface and on a surface opposite to the one surface. The electrode terminals 142P and 142N may protrude from the corresponding surfaces. The electrode terminal 142P is electrically connected to a positive electrode of the battery cell 142. The electrode terminal 142P may be referred to as a positive electrode terminal or a P terminal. The electrode terminal 142N is electrically connected to the negative electrode of the battery cell 142. The electrode terminal 142N may be referred to as a negative electrode terminal or an N terminal. The electrode terminal may be referred to as a battery cell terminal, a current collecting tab, or the like.

The battery cell 142 shown in FIGS. 4 and 5 has a rectangular shape, specifically, a flat shape that is thin in the Y direction. The multiple battery cells 142 are arranged side by side in the X direction. The electrode terminals 142P and 142N are provided on one of end faces in the Z direction, that is, on a common surface. The multiple battery cells 142 are arranged such that the electrode terminals 142P and the electrode terminals 142N are positioned alternately in the Y direction. In the adjacent battery cells 142, the electrode terminals 142P and the electrode terminals 142N are electrically connected to each other by a bus bar (not shown).

The assembled battery 141 may include multiple battery cells 142 arranged in the Y direction. The arrangement of the battery cells 142 is not limited to the above arrangement. For example, in the case of the cylindrical battery cells 142, the battery cells 142 may be arranged in a staggered pattern when viewed in a plan view in the Z direction.

### <Temperature Unevenness>

As described above, the battery 14 that drives the EPU 15 is required to discharge a large current for a certain period of time during the vertical movement, particularly during the takeoff and landing. For example, during the takeoff and landing, the battery 14 discharges continuously (continually) at a maximum discharge rate of about 3 C to about 15 C for about 30 seconds to about 90 seconds.

The discharge rate indicates a ratio of the current during discharge relative to the battery capacity, and is expressed in the unit of C. A discharge rate of 1C indicates a current value at which a cell having a nominal capacity value is discharged at a constant current until the discharge is completed in one hour. The maximum discharge rate for an electric flight vehicle during cruising and an electric vehicle (BEV) is about 1C to 2C. In the case of a BEV, this is a level where the maximum discharge rate continues for about 5 to 10 seconds. BEV is an abbreviation for Battery Electric Vehicle. Thus, there is a large variation in the discharge characteristic between the takeoff and landing and the cruising.

As described above, the vertical movement, particularly the takeoff and landing, requires the battery 14 to discharge a higher current for a longer period of time than that during the cruising and that of the BEV. Due to the discharge, the battery 14 generates heat, and its temperature rises. During the discharge of a large current, the temperature rises significantly, and concentration of a current in a specific portion inside the battery cell 142 causes more apparent temperature unevenness. The temperature unevenness inside the battery cell 142 is a temperature distribution or a temperature unevenness inside the battery cell 142.

During the discharge of a large current, concentration of a current is likely to occur in the vicinity of the electrode terminals 142P and 142N. The temperature of the battery cell 142 is highest at or in the vicinity of the electrode terminals 142P and 142N, and is lowest at a position away from the electrode terminals 142P and 142N. In a configuration in which the electrode terminals 142P and 142N are arranged on a common surface, a current is likely to concentrate on the surface on which the electrode terminals 142P, 142N are arranged, and a current is unlikely to concentrate on the opposite surface. In a configuration in which the electrode terminal 142P is arranged on one surface and the electrode terminal 142N is arranged on the opposite surface, a current is likely to concentrate in the vicinity of the electrode terminals 142P and 142N, but is unlikely to concentrate in the vicinity of the center of the battery cell 142.

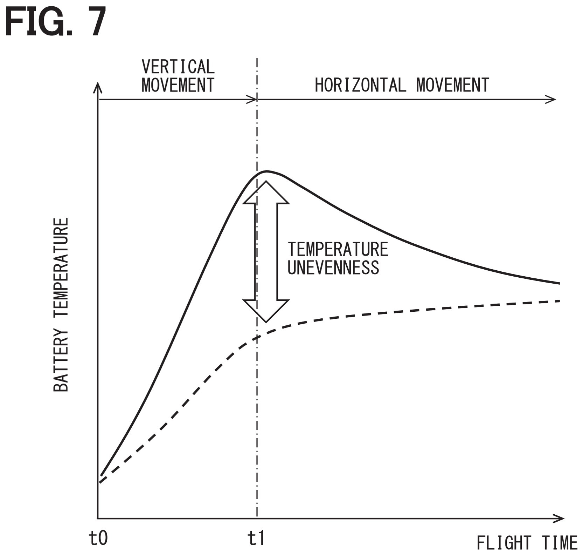

FIG. 7 shows a relationship between a flight time and the battery temperature. The solid line indicates a temperature of a region where a current tends to concentrate during discharge of a large current. The dashed line indicates a temperature of a region where concentration of a current is unlikely to occur during discharge of a large current. FIG. 7 shows a change in temperature when the eVTOL 10 begins takeoff at time t0, moves in the vertical direction until time t1, and then moves in the horizontal direction after time t1. As described above, concentration of a current occurs, and the temperature rise becomes noticeable in the region where a current is concentrated. Thereafter, the temperature is alleviated by conduction to a region where a current is less likely to concentrate during discharge of a large current, by external release of accumulated heat, and by conduction to another cell at a low-temperature. In this manner, the region where a current is likely to concentrate experiences greater temperature fluctuations than a region where a current is less likely to concentrate. During discharge of a large current, temperature unevenness occurs inside the battery cell 142.

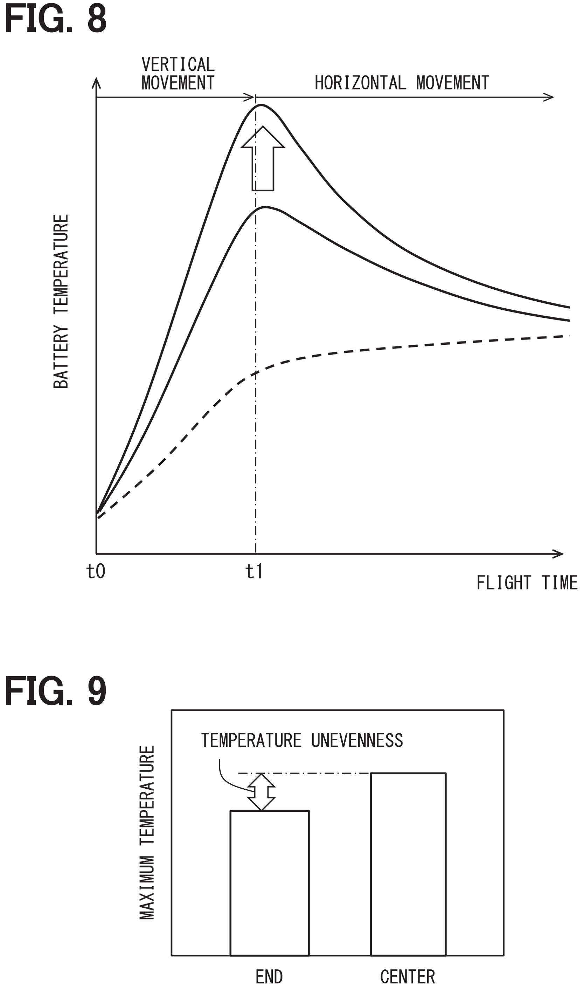

The temperature unevenness causes deterioration, in other words, partial deterioration in a part of the battery cells 142 constituting the assembled battery 141, particularly a part inside the battery cells 142. At the partially deteriorated portion, an electric resistance increases. This causes further heat generation in the next discharge of a large current, resulting in a vicious circle in which the temperature unevenness increases. Repetition of this progresses the partial deterioration, and the temperature unevenness increases as shown in FIG. 8. The white arrows in FIG. 8 indicates increase in the temperature unevenness that accompanies the progress of the partial degradation. As the partial degradation progresses through the repetition, it may lead to abnormal degradation in which the capacity drops suddenly or thermal runaway. The thermal runaway may occur, for example, when metallic lithium is deposited or when localized abnormal heat is generated during charging, causing the separator to break and short-circuit. In an electric flight vehicle such as the eVTOL10, active cooling during flight is difficult due to the need to reduce weight, making the problem of temperature unevenness more likely to become apparent.

The temperature unevenness of the battery 14 also becomes apparent due to variation in heat dissipation within the assembled battery 141. In the assembled battery 141, due to difference in a heat dissipation property, heat tends to accumulate in the battery cell 142 located in the vicinity of the center, and heat tends to escape from the battery cell 142 located at the end. For example, in the example shown in FIG. 5, heat is likely to accumulate in the battery cell 142 located in the vicinity of the center among the multiple battery cells 142 stacked in the Y direction. For this reason, as shown in FIG. 9, a difference in maximum temperature occurs between the battery cell 142 located in the center and the battery cell 142 located at the end. That is, the temperature unevenness occurs between the battery cells 142. The temperature unevenness inside the assembled battery 141 is a temperature distribution inside the assembled battery 141, that is, a temperature variation among the multiple battery cells 142.

In the assembled battery 141, deterioration or abnormality of a part of the battery cells 142 may lead to deterioration or abnormality of the assembled battery 141 itself, which may lead to rapid deterioration or thermal runaway of the assembled battery 141. When charging and discharging of a part of the battery cells 142 is restricted, the assembled battery 141 itself is also restricted. If a part of the battery cells 142 experience thermal runaway, the heat may be conducted to the other battery cells 142, causing a chain reaction of thermal runaway.

In order to extend a flight distance of an electric flight vehicle, battery cells 142 with high energy density and which can be made lighter are required. Currently, the positive electrode materials used in many of the high energy density cells on the market, such as the above-mentioned LCO, NMC, and NCA, are compounds with a layered structure, and charging and discharging are carried out by movement of lithium ions between the layers. The reaction resistance is higher during discharge, when lithium ions are inserted between the layers, compared to during charging, when lithium ions are removed from between the layers. In other words, it becomes difficult for ions to enter or leave between the layers. For this reason, the battery cell 142 using the layered compound-based positive electrode has a high resistance during discharge, and is likely to accelerate temperature rise and expansion of the temperature unevenness that accompanies the temperature rise.

### <Monitoring Device>

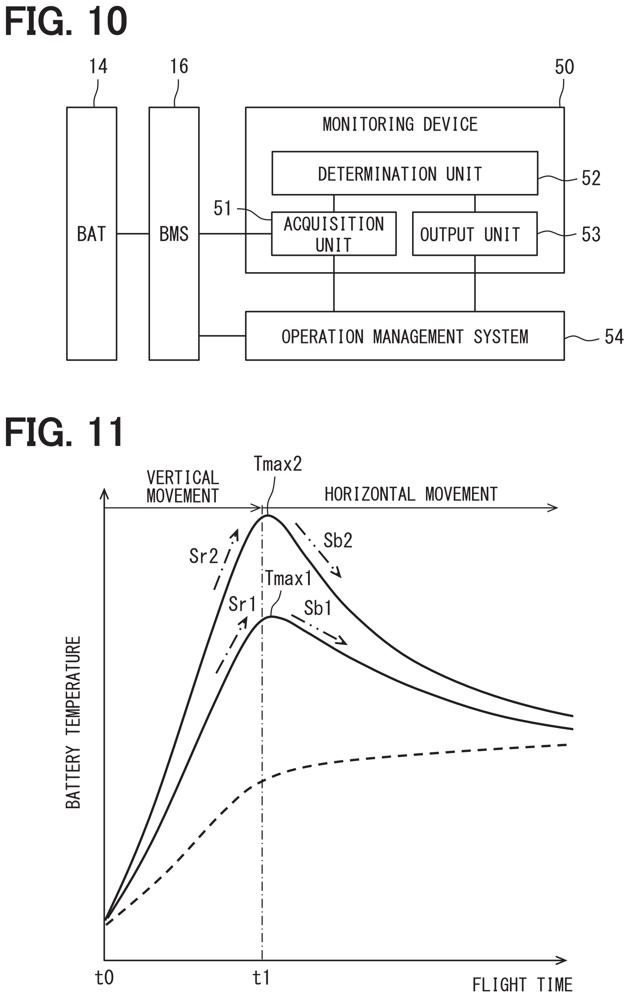

FIG. 10 shows a monitoring device. The monitoring device 50 monitors the battery 14. A functional arrangement of the monitoring device 50 is not particularly limited. At least a part of the functions of the monitoring device 50 may be located inside the flight vehicle or outside the flight vehicle. The functions of the monitoring device 50 may be distributed across multiple devices inside the flight vehicle. The functions of the monitoring device 50 may be distributed across multiple devices outside the flight vehicle. A part of the functions of the monitoring device 50 may be located inside the flight vehicle, and another part of the functions may be located outside the flight vehicle.

For example, at least a part of the functions of the monitoring device 50 may be located in the BMS 16. At least a part of the functions of the monitoring device 50 may be arranged in the ECU 20. At least a part of the functions of the monitoring device 50 may be arranged in the server 31 of the ground station 30. At least a part of the functions of the monitoring device 50 may be arranged in the operation management system 40. At least a part of the functions of the monitoring device 50 may be arranged in the internal management unit 42. At least a part of the functions of the monitoring device 50 may be arranged in the external management unit 41.

As shown in FIG. 10, the monitoring device 50 may include an acquisition unit 51, a determination unit 52, and an output unit 53. The acquisition unit 51 acquires information (temperature unevenness information) on the temperature unevenness of the battery 14 that occurs as the eVTOL 10 moves in the vertical direction. The acquisition unit 51 may acquire information on the temperature unevenness that occurs during takeoff and/or landing as temperature unevenness information. In the case where the vehicle temporarily moves in the vertical direction while cruising, the acquisition unit 51 may acquire information on the temperature unevenness that occurs with the movement in the vertical direction while cruising as the temperature unevenness information. The acquisition unit 51 may acquire information on the temperature unevenness that occurs with the movement in the vertical direction during cruising, in addition to the information on the temperature unevenness that occurs with the takeoff and landing.

The temperature unevenness occurs between the battery cells 142 in the assembled battery 141. The monitoring device 50 may monitor the temperature difference between the multiple battery cells 142 in the assembled battery 141. The acquisition unit 51 may acquire the temperatures of multiple battery cells 142. As described above, the temperature of the assembled battery 141 becomes higher in the vicinity of the center. Therefore, the acquisition unit 51 may acquire the temperature of at least the battery cells 142 arranged in the vicinity of the center of the assembled battery 141. Furthermore, the acquisition unit 51 may acquire the temperature of the battery cell 142 arranged in the vicinity of the end that is excellent in a heat dissipation property.

The temperature unevenness occurs inside the battery cell 142. The acquisition unit 51 may acquire information on the temperature unevenness inside the battery cell 142. Temperatures at multiple locations in one battery cell 142 may be acquired as the temperature unevenness information. As shown in FIG. 11, as the partial deterioration progresses, a rate of increase in the temperature to the maximum temperature increases with the movement in the vertical direction. FIG. 11 corresponds to FIG. 8 and shows a state in which the partial degradation has progressed, and the maximum reached temperature has increased from Tmax1 to Tmax2.

The rate of increase Sr2 to the maximum reached temperature Tmax2 is greater than the rate of increase Sr1 to the maximum reached temperature Tmax1. In addition, as the partial degradation progresses, the relaxation rate after the maximum temperature is reached increases. A relaxation speed Sb2 after the maximum temperature Tmax2 is reached is greater than the relaxation speed Sb1 after the maximum temperature Tmax1 is reached. That is, the greater the temperature unevenness, the greater a gradient of the temperature change. The acquisition unit 51 may use, as the temperature unevenness information, a temperature rise characteristic before the maximum reached temperature and/or the temperature relaxation characteristic after the maximum reached temperature. By using these parameters, it is possible to monitor the temperature unevenness (degree of temperature unevenness) in the battery cell 142 even with temperature information at a single location. For example, the temperature in the vicinity of the electrode terminal 142P of the battery cell 142 located in the vicinity of the center of the assembled battery 141 may be acquired.

The parameter related to the temperature of the battery 14 is affected by a discharge characteristic, an environmental temperature, and the like. Therefore, by taking a fluctuation in these parameters into consideration, it is possible to improve the accuracy of the abnormality determination. As the discharge characteristic information, that is, the parameter indicating the discharge characteristic during the movement in the vertical direction, a discharge power amount (Wh) or a discharge capacity (Ah) may be used. Alternatively, an integral value of a square of the discharge current or an integral value accumulated over a predetermined time period may be used. When the discharge power or the discharge current during the movement in the vertical direction is approximately constant, a discharge time period may be used. When the discharge time during the movement in the vertical direction is approximately constant, the discharge power or the discharge current may be used. When the discharge time is approximately constant, a square of the discharge current may be used instead of the discharge current. Instead of the above-described discharge current, a discharge rate may be used. For example, a temperature, a wind speed, a wind direction, and the like may be used as the environmental information.

The acquisition unit 51 may acquire information such as the temperature unevenness information and the discharge characteristic information from the BMS 16 or the operation management system 40. The acquisition unit 51 may acquire, as the information, an actual measured value or an intermediate calculated value. The acquisition unit 51 may acquire, as the information, a calculated value such as a feature amount indicating the discharge characteristic. The information may be acquired by performing calculation within the monitoring device 50 based on the actual measurement and an intermediate calculated value acquired from the BMS 16, the operation management system 40, and the like. The acquisition unit 51 acquires information through wireless communication and/or wired communication.

The determination unit 52 determines whether there is a battery abnormality based on the temperature unevenness information acquired by the acquisition unit 51. The determination unit 52 detects the battery abnormality. The determination unit 52 corresponds to a detection unit. The determination unit 52 determines that there is an abnormality when the temperature unevenness or a degree of partial deterioration, which is estimated from the temperature unevenness, exceeds a predetermined threshold. The calculation for estimating the degree of partial deterioration may be executed by the determination unit 52 or may be executed by the acquisition unit 51. In the monitoring device 50, a calculation unit, which is different from the acquisition unit 51 and the determination unit 52, may implement the execution.

The predetermined threshold may be set based on the temperature unevenness (degree of temperature unevenness) or the degree of partial deterioration at which it is determined that abnormal deterioration of the battery 14 has occurred or possibility of metallic lithium precipitation has occurred. The threshold may be set with a predetermined margin. The threshold may be set in advance by performing an experiment using a sample cell. For example, the predetermined threshold may be set by analyzing a relationship among the temperature unevenness, the abnormal deterioration, and deposition of metallic lithium through an experiment in advance. The predetermined threshold may be set by analyzing, through an experiment in advance, a relationship between the temperature unevenness and the degree of partial deterioration, and a relationship among the degree of partial deterioration, the abnormal deterioration, and the deposition of metallic lithium. In the experiment in advance, for example, each of the battery cells, in which the temperature unevenness has occurred in a large current discharge test (various conditions), may be disassembled to check a partial deterioration state of the electrodes.

As described above, the determination unit 52 may determine presence or absence of an abnormality using only the temperature unevenness information. For example, when the flight route is fixed and the discharge characteristic do not change significantly from flight to flight, the threshold can be easily determined based on the temperature unevenness information alone. As described above, the parameter related to the temperature of the battery 14 is affected by the discharge characteristic, the environmental temperature, and the like. Therefore, variations in these parameters may also be taken into account. The determination unit 52 may determine the presence or absence of an abnormality based on the temperature unevenness information corrected using information such as the discharge characteristic and the environmental temperature.

The determination unit 52 may determine the presence or absence of an abnormality by using information on the degree of partial deterioration based on the temperature unevenness information. The degree of partial deterioration may be estimated only from the temperature unevenness information. For example, by determining a relationship between the temperature unevenness and the degree of partial deterioration while taking into account fluctuation in the discharge characteristic information and the environmental information during the movement in the vertical direction, the accuracy of abnormality determination can be improved. The above-described experiment may be performed, and the relationship may be derived using a regression model constructed by a map model or machine learning.

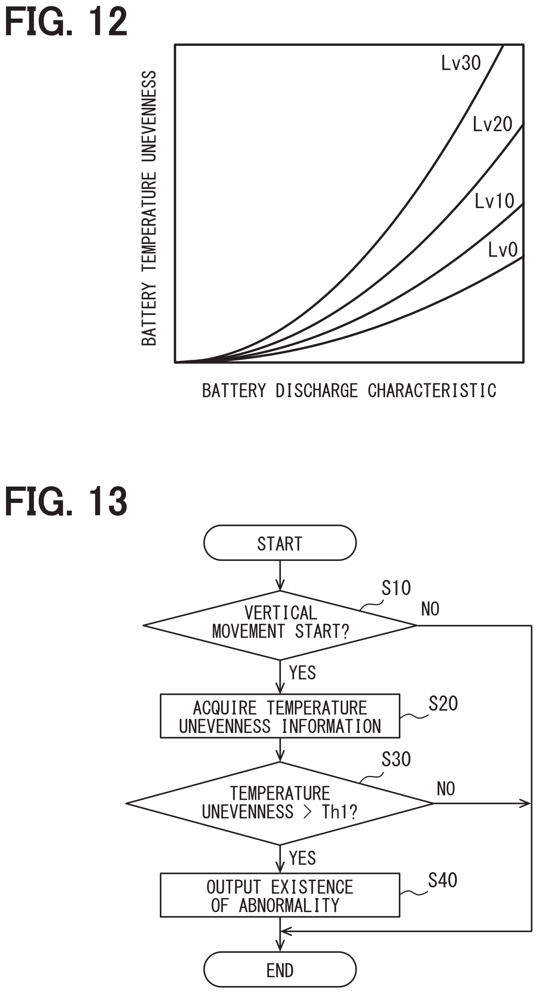

FIG. 12 is a view showing an example of a relationship among the battery discharge characteristic, the battery temperature unevenness, and the degree of partial deterioration. FIG. 12 shows the relationship at an environmental temperature of 20°C. Each of Lv0, Lv10, Lv20, and Lv30 indicates the degree of partial deterioration. The larger the value, the more advanced the partial deterioration. The determination unit 52 may set the detection level, that is, the determination threshold, in multiple stages. For example, when the degree of partial deterioration exceeds Lv10 (first determination threshold) shown in FIG. 12, the determination unit 52 may determine that an abnormality exists and that a warning should be output. When the degree of partial deterioration exceeds Lv20 (second determination threshold), it may be determined that an abnormality exists and that an avoidance operation should be performed. It should be noted that Lv0 indicates an initial value when no partial degradation occurs. Lv30 indicates the upper limit, and anything above Lv30 is in an abnormality occurrence range.

The output unit 53 outputs the determination result of an abnormality to an outside of the monitoring device 50. The output unit 53 outputs a monitoring result when a predetermined condition related to an abnormality is satisfied based on the temperature unevenness information. The output unit 53 may output the determination result, for example, to issue an alarm to a crew or the ground station 30. The output unit 53 may output the determination result to trigger a transition to the avoidance operation. The output unit 53 may output the determination result to the operation management system 40 that displays an operational status of the flight vehicle and controls the operation. The monitoring device 50 itself may implement the display. The output unit 53 may output a control request for the avoidance operation to a control device that controls the flight. The control device may be provided integrally as one function of the operation management system 40, or may be provided separately.

The output unit 53 may implement the output in multiple stages, for example, may issue the warning in a first stage and may perform the avoidance operation in a second stage or later. As the avoidance operation, for example, redundant operation of the battery 14 may be implemented, or an emergency landing operation may be implemented. The redundant operation of the battery 14 may, for example, stop output of a system that shows a sign of an abnormality and continue the flight using the remaining system. As the avoidance action, multiple actions may be implemented simultaneously. The avoidance action may be a step-by-step action. The output unit 53 may estimate a time period until an abnormality occurs based on a time series transition of the target information, and output the estimated time period as urgency information.

### <Monitoring method>

As described above, the monitoring device 50 may be arranged in the ECU 20 of the eVTOL 10. In this case, execution of processing of each functional block of the monitoring device 50 by the processor 201 corresponds to execution of the monitoring method. The monitoring device may be located at the server 31 of the ground station 30. In this case, execution of processing of each functional block of the monitoring device 50 by the processor 311 corresponds to execution of the monitoring method.

As the monitoring method, for example, a method shown in FIG. 13 may be used. The monitoring device 50 (e.g., the processor 201) repeatedly executes the process shown in FIG. 13 at a predetermined cycle. First, the monitoring device 50 determines whether the eVTOL 10 has started movement in the vertical direction (step S10). Instead of the start of the movement in the vertical direction, start of takeoff flight or start of landing flight may be used.

When the movement in the vertical direction has not started, the monitoring device 50 ends the series of processes. When the movement in the vertical direction is started, the monitoring device 50 acquires the temperature unevenness information (step S20). The monitoring device 50 compares the acquired temperature unevenness with a predetermined threshold Th1, and determines whether the temperature unevenness (degree of temperature unevenness) is greater than the threshold Th1 (step S30).

When the temperature unevenness is greater than the threshold Th1, the monitoring device 50 determines that there is an abnormality in the battery 14 and outputs presence of an abnormality (step S40), and ends the series of processes. When the temperature unevenness is equal to or smaller than the threshold Th1, the monitoring device 50 does not execute the process of step S40 and ends the series of processes.

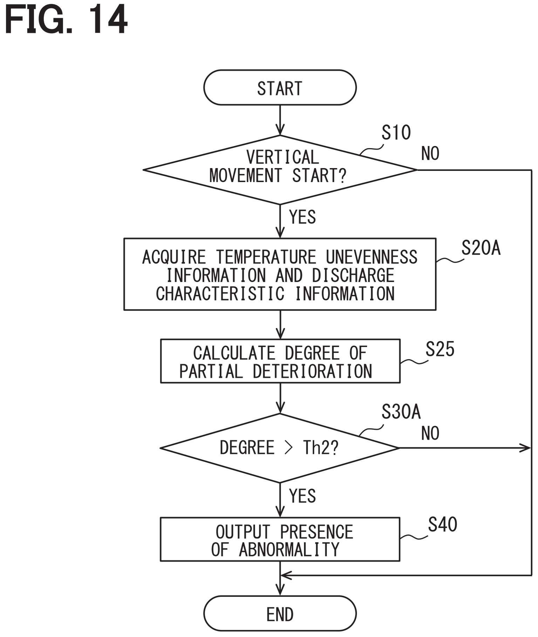

As the monitoring method, a method shown in FIG. 14 may be used. First, the monitoring device 50 executes the process of step S10 in the same manner as in the method shown in FIG. 13. When the eVTOL 10 starts movement in the vertical direction, the monitoring device 50 acquires the temperature unevenness information and the discharge characteristic information (step S20A) instead of the process of step S20. Next, the monitoring device 50 calculates the degree of partial deterioration based on the temperature unevenness information acquired in step S20A (step S25). Next, the monitoring device 50 calculates the degree of partial deterioration based on the the discharge characteristic information (step S25). The monitoring device 50 estimates the degree of partial deterioration through calculation.

Next, instead of the process of step S30, the monitoring device 50 compares the acquired degree of partial deterioration with a predetermined threshold Th2, and determines whether the degree of partial deterioration is greater than the threshold Th2 (step S30A). When the degree of partial deterioration is greater than the threshold Th2, the process of step S40 is executed in the same manner as in the method shown in FIG. 13, and the series of processes is terminated. When the degree of partial deterioration is equal to or smaller than the threshold Th2, the monitoring device 50 does not execute the process of step S40 and ends the series of processes.

In the method shown in FIG. 13, when the temperature unevenness is equal to or less than the threshold Th1, the monitoring device 50 may output presence of no abnormality, and then may end the series of processes. Similarly, in the method shown in FIG. 14, when the degree of partial deterioration is equal to or less than the threshold Th2, the monitoring device 50 may output presence of no abnormality, and then may end the series of processes.

In the method shown in FIG. 13, after the temperature unevenness information is acquired, the degree of partial deterioration may be calculated based on the temperature unevenness information. Then, the degree of partial deterioration may then be compared with a predetermined determination threshold to determine whether an abnormality exists. In the method shown in FIG. 14, after acquiring the temperature unevenness information and the discharge characteristic information, the temperature unevenness information, which is corrected by the discharge characteristic information, may be compared with a predetermined determination threshold to determine presence or absence of an abnormality.

As shown in FIGS. 13 and 14, an example of the monitoring method has been shown. In the example, when movement in the vertical direction is detected, the information is acquired, the determination is made, and the determination result is output in succession. However, it is also possible to acquire the temperature unevenness information accompanying the movement in the vertical direction during flight, and perform the determination process and output process after the flight. The determination process and the output process may be performed before the next flight.

### Summary of First Embodiment:

As described above, when the eVTOL 10 (electric flight vehicle) moves in the vertical direction, the battery 14 is required to discharge a large current for a certain period of time. This causes the temperature unevenness to become apparent inside the battery 14, and the temperature unevenness causes the partial deterioration of the battery 14. As the partial deterioration occurs in the battery, the electric resistance of the battery increases. This causes even more heat when discharging a large current, and promotes the further partial deterioration. The progress of the partial deterioration may lead to an abnormality such as rapid deterioration or thermal runaway of the battery 14.

The monitoring device 50 of the present embodiment acquires the information on the temperature unevenness of the battery that occurs as the eVTOL 10 moves in the vertical direction. When the predetermined condition, which is related to an abnormality in the battery 14, is satisfied based on the information on the temperature unevenness, the monitoring result is output. By monitoring the temperature unevenness in this way, an abnormality that occur as a result of the progress of the partial deterioration can be detected in an early stage. Thus, the safety of the flight can be enhanced.

The monitoring device 50 may acquire the information on the discharge characteristic during the movement in the vertical direction together with the temperature unevenness information, and may output the monitoring result based on the temperature unevenness information and the discharge characteristic information. The discharge characteristic changes slightly for each flight. Therefore, by adding the discharge characteristic information to the temperature unevenness information, the condition of each flight can be reflected, and an abnormality such as abnormal deterioration and thermal runaway can be detected with high accuracy.

The monitoring device 50 may monitor the temperature unevenness accompanied with the takeoff flight and/or the landing flight of the eVTOL 10. By monitoring the temperature unevenness that occurs during the takeoff and the landing, when the greatest power output is required during the flight, in other words, the temperature unevenness at its maximum, accuracy of detection of an abnormality can be further improved.

The monitoring device 50 may monitor the temperature unevenness that occurs with the movement in the vertical direction when the discharge rate of the battery 14 is 3C or higher and the duration of this discharge is 30 seconds or longer. By monitoring the temperature unevenness in the maximized state, accuracy of the detection of an abnormality can be further improved.

As described above, an electric flight vehicle such as the eVTOL 10 have a large fluctuations in the discharge characteristic. As the variation in the discharge characteristic becomes greater, the temperature unevenness likely spreads, and the effect of early detection by the monitoring device 50 can be improved. For example, when the ratio of the maximum discharge rate during the movement in the vertical direction to the maximum discharge rate during the movement in the horizontal direction is 1.5 or more, the effect of early detection is enhanced. When the ratio is even higher, for example, 2 times or more, 3 times or more, or 5 times or more, a greater effect can be achieved. As the maximum discharge rate during the takeoff and the landing becomes higher, the effect of the early detection by the monitoring device 50 can be further enhanced. When the maximum discharge rate is 3C or more, the effect of early detection is enhanced. When the maximum discharge rate is even higher, for example, 5C or more, 7C or more, or 10C or more, a greater effect can be achieved.

The monitoring device 50 may acquire the temperature unevenness information of the battery 14 including the battery cell 142 that contains a layered compound material as the positive electrode material. As described above, the battery cell 142 using the positive electrode containing the layered compound material has a high electric resistance during discharge, and therefore tends to accelerate the expansion of the temperature unevenness. Therefore, monitoring temperature variations enables to improve the flight safety in particular.

The monitoring device 50 may acquire information on the temperature unevenness inside the battery cells 142 as the temperature unevenness information. The temperature unevenness becomes apparent due to concentration of a current in a specific portion inside the battery cell 142. Therefore, by acquiring the information on the temperature unevenness inside the battery cell 142, a sign of an abnormality can be detected with high accuracy.

The monitoring device 50 may have a temperature rise characteristic before the maximum temperature is reached and/or a temperature relaxation characteristic after the maximum temperature is reached at the electrode terminals 142P and 142N of the battery cell 142 or in the vicinity of the electrode terminals 142P and 142N, accompanied with the movement of the electric flight vehicle in the vertical direction. During the discharge of a large current, concentration of a current is likely to occur in the vicinity of the electrode terminals 142P and 142N. By monitoring the vicinity of the electrode terminals 142P and 142N, which are likely to cause the temperature unevenness and likely to cause a large temperature change due to the temperature unevenness, it is possible to grasp change in the state with high accuracy. Both the temperature rise characteristic before the maximum temperature is reached and the temperature relaxation characteristic after the maximum temperature is reached are parameters that indicate the state of the temperature unevenness with excellent reproducibility and high accuracy. Therefore, the change in the temperature unevenness can be monitored with high accuracy. It is possible to monitor the temperature unevenness information even at one location, and the configuration can be simplified without compromising its quality.

The monitoring device 50 may include, as the temperature unevenness information, information on the electrode terminals 142P and 142N of the battery cell 142 arranged in the vicinity of the center of the assembled battery 141 or information in the vicinity of the electrode terminals 142P and 142N. By monitoring the vicinity of the center where heat tends to build up, the worst state inside the assembled battery 141 can be directly monitored. Therefore, it is possible to improve the accuracy of abnormality determination.

The program is stored in the storage medium and includes instructions to be executed by the processor to monitor the battery 14. The program includes instructions to acquire the information on the temperature unevenness of the battery 14 accompanied with the movement of the eVTOL 10 in the vertical direction, and to output the monitoring result when a predetermined condition related to an abnormality in the battery 14 is satisfied based on the information on the temperature unevenness. By monitoring the temperature unevenness in this way, an abnormality that occur as a result of the progress of the partial deterioration can be detected in an early stage. Thus, the safety of the flight can be enhanced.

The monitoring device 50 acquires a characteristic including the temperature rise characteristics of the battery 14 before the maximum temperature is reached and/or the temperature relaxation characteristics after the maximum temperature is reached, accompanied with the movement of the eVTOL 10 in the vertical direction. Then, when a predetermined condition related to an abnormality of the battery 14 is satisfied based on the acquired characteristic, the monitoring result may be output. Since the state of the battery 14 is monitored using the temperature rise characteristics before the maximum temperature is reached and/or the temperature relaxation characteristics after the maximum temperature is reached, abnormalities in the battery 14 due to the progression of deterioration can be detected early. Thus, the safety of the flight can be enhanced.

The monitoring device 50 may include at least the acquisition unit 51 and the output unit 53. The acquisition unit 51 may acquire the information on the temperature unevenness of the battery 14 accompanied with the movement of the eVTOL 10 in the vertical direction. The output unit 53 may output the monitoring result when the predetermined condition on an abnormality of the battery 14 is satisfied based on the information on the temperature unevenness. The acquisition unit 51 may acquire the characteristic including the temperature rise characteristics of the battery 14 before the maximum temperature is reached and/or the temperature relaxation characteristics after the maximum temperature is reached, accompanied with the movement of the eVTOL 10 in the vertical direction. The output unit 53 may output the monitoring result, when the predetermined condition related to an abnormality of the battery 14 is satisfied based on the characteristic.

### (Other Embodiments)

The disclosure in this specification and drawings is not limited to the exemplified embodiments. The disclosure encompasses the illustrated embodiments and modifications by those skilled in the art based thereon. For example, the disclosure is not limited to the combinations of components and/or elements shown in the embodiments. The disclosure may be implemented in various combinations. The disclosure may have additional portions that may be added to the embodiments. The disclosure encompasses omission of components and/or elements of the embodiments. The disclosure encompasses the replacement or combination of components and/or elements between one embodiment and another. The disclosed technical scope is not limited to the description of the embodiments. Some aspects of the disclosed technical scope are indicated by the recitations of the claims, and should further be construed to include all modifications within the meaning and scope equivalent to those recitations.

The disclosure in the specification, drawings and the like is not limited by the description of the claims. The disclosures in the specification, the drawings, and the like encompass the technical ideas described in the claims, and further extend to a wider variety of technical ideas than those in the claims. Therefore, various technical ideas can be extracted from the disclosure of the specification, the drawings and the like without being limited to the description of the claims.

When an element or a layer is described as "disposed above" or "connected", the element or the layer may be directly disposed above or connected to another element or another layer, or an intervening element or an intervening layer may be present therebetween. In contrast, when an element or a layer is described as "disposed directly above" or "directly connected", an intervening element or an intervening layer is not present. Other terms used to describe the relationships between elements (for example, "between" vs. "directly between", and "adjacent" vs. "directly adjacent") should be interpreted similarly. As used herein, the term "and/or" includes any combination and all combinations relating to one or more of the related listed items. For example, the term A and/or B includes only A, only B, or both A and B.

Each of the various flowcharts shown in the present disclosure is an example, and the number of steps constituting the flowchart and the execution order of the process can be appropriately changed. The device, the system and the method therefor described in the present disclosure may be implemented by a dedicated computer which constitutes a processor programmed to perform one or more functions by executing computer programs. The device and the method described in the present disclosure may be also implemented by a dedicated hardware logic circuit. Furthermore, the device and the method thereof described in the present disclosure may be implemented by one or more special purpose computers formed by a combination of a processor that executes computer programs and one or more hardware logic circuits.

For example, a part or all of the functions of the processor 311 may be realized as hardware. An aspect in which a certain function is implemented as hardware includes an aspect in which one or multiple ICs are used. As the processor (arithmetic core), a CPU, an MPU, a GPU, a DFP, or the like can be adopted. The CPU is an abbreviation of a central processing unit. The MPU is an abbreviation of a micro-processing unit. The GPU is an abbreviation of a graphics processing unit. The DFP is an abbreviation of a data flow processor.

A part or all of the functions of the processor 201 may be implemented by combining multiple types of calculation processing devices. A part or all of the functions of the processor 201 may be implemented using an SoC, ASIC, FPGA, or the like. The SoC is an abbreviation of a system-on chip. The ASIC is an abbreviation of an application specific integrated circuit. The FPGA is an abbreviation of a field programmable gate array. The same applies to the processor 311.

The computer program may be stored in a computer-readable non-transitionary tangible recording medium (non-transitory tangible storage medium) as an instruction to be executed by the computer. As the program storage medium, an HDD, an SSD, a flash memory, or the like can be adopted. The HDD is an abbreviation of a hard disk drive. SSD is an abbreviation for Solid State Drive. The scope of the present disclosure also includes a program causing a computer to function as the controller or the control system, and forms such as a non-transitory tangible storage medium such as a semiconductor memory in which the program is stored.

### (Disclosure of Technical Ideas)

This description discloses multiple technical ideas described in multiple items listed below. Some items may be written in a multiple dependent form with subsequent items referring to the preceding item as an alternative. Some items may be written in a multiple dependent form referring to another multiple dependent form. These items written in a multiple dependent form define multiple technical ideas.

### <Technical idea 1>

A monitoring device is configured to monitor a battery (14) mounted on an electric flight vehicle (10). The monitoring device comprises: an acquisition unit (51) configured to acquire information on temperature unevenness of the battery, the temperature unevenness being caused due to movement of the electric flight vehicle in the vertical direction; and an output unit (53) configured to output a monitoring result, when a predetermined condition related to an abnormality of the battery is satisfied based on the information on the temperature unevenness.

### (Technical idea 2)

The monitoring device according to technical idea 1, in which the acquisition unit is configured to acquire information on a discharge characteristic during the movement in the vertical direction, together with the information on the temperature unevenness of the battery, and the output unit is configured to output the monitoring result based on the information on the temperature unevenness and the information on the discharge characteristic.

### (Technical idea 3)

The monitoring device according to technical idea 1 or 2, in which the movement in the vertical direction is takeoff flight and/or landing flight.

### <Technical idea 4>

The monitoring device according to technical idea 3, in which a discharge rate of the battery during the movement in the vertical direction is 3C or more, and a duration thereof is 30 seconds or more.

### <Technical idea 5>

The monitoring device according to any one of technical ideas 1 to 4, in which the battery includes a plurality of battery cells (142), and the battery cell includes a layered compound material as a positive electrode material.

### <Technical idea 6>

The monitoring device according to any one of technical ideas 1 to 5, in which the battery includes an assembled battery (141) including a plurality of battery cells (142), and the information on the temperature unevenness includes information on the temperature unevenness inside the battery cell.

### <Technical idea 7>

The monitoring device according to technical idea 6, in which the battery cell includes an electrode terminal (142P, 142N), and the information on the temperature unevenness includes a temperature rise characteristics, which is before reaching a maximum temperature, and/or a temperature relaxation characteristics, which is after reaching the maximum temperature, at the electrode terminal of the battery cell or in the vicinity of the electrode terminal and caused due to the movement of the electric flight vehicle in the vertical direction.

### <Technical ides 8>

The monitoring device according to technical idea 7, in which the information on the temperature unevenness includes information on the electrode terminal of the battery cell in the vicinity of a center of the assembled battery or information on a portion in the vicinity of the electrode terminal.

## Claims

1. A monitoring device configured to monitor a battery (14) mounted on an electric flight vehicle (10), the monitoring device comprising:
an acquisition unit (51) configured to acquire information on temperature unevenness of the battery, the temperature unevenness being caused due to movement of the electric flight vehicle in a vertical direction; and
an output unit (53) configured to output a monitoring result, when a predetermined condition related to an abnormality of the battery is satisfied based on the information on the temperature unevenness.

2. The monitoring device according to claim 1, wherein
the acquisition unit is configured to acquire information on a discharge characteristic during the movement in the vertical direction, together with the information on the temperature unevenness of the battery, and
the output unit is configured to output the monitoring result based on the information on the temperature unevenness and the information on the discharge characteristic.

3. The monitoring device according to claim 1 or 2, wherein
the movement in the vertical direction is takeoff flight and/or landing flight.

4. The monitoring device according to claim 3, wherein
a discharge rate of the battery during the movement in the vertical direction is 3C or more, and a duration thereof is 30 seconds or more.

5. The monitoring device according to claim 1, wherein
the battery includes a plurality of battery cells (142), and
the battery cell includes a layered compound material as a positive electrode material.

6. The monitoring device according to claim 1, wherein
the battery includes an assembled battery (141) including a plurality of battery cells (142), and
the information on the temperature unevenness includes information on the temperature unevenness inside the battery cell.

7. The monitoring device according to claim 6, wherein
the battery cell includes an electrode terminal (142P, 142N), and
the information on the temperature unevenness includes a temperature rise characteristics, which is before reaching a maximum temperature, and/or a temperature relaxation characteristics, which is after reaching the maximum temperature, at the electrode terminal of the battery cell or in the vicinity of the electrode terminal and caused due to the movement of the electric flight vehicle in the vertical direction.

8. The monitoring device according to claim 7, wherein
the information on the temperature unevenness includes information on the electrode terminal of the battery cell in the vicinity of a center of the assembled battery or information on a portion in the vicinity of the electrode terminal.

9. A program stored in a storage medium (203) for monitoring a battery (14), which is mounted on an electric flight vehicle (10), the program comprising: instructions to be executed by a processor (201) to cause the processor to
acquire information on temperature unevenness of the battery, the temperature unevenness being caused due to movement of the electric flight vehicle in a vertical direction, and
output a monitoring result, when a predetermined condition related to an abnormality of the battery is satisfied based on the information on the temperature unevenness.

10. A monitoring device configured to monitor a battery (14) mounted on an electric flight vehicle (10), the monitoring device comprising:
an acquisition unit (51) configured to acquire a characteristic including a temperature rise characteristics of the battery, which is before reaching a maximum temperature, and/or a temperature relaxation characteristics of the battery, which is after reaching the maximum temperature, due to movement of the electric flight vehicle in a vertical direction; and
an output unit (53) configured to output a monitoring result, when a predetermined condition related to an abnormality of the battery is satisfied based on the characteristic.
